# EUROPEAN PATENT APPLICATION

(11) **EP 3 699 352 A1**
(43) Date of publication of application: **26.08.2020**
(21) Application number: 20158174.1
(22) Date of filing: 19.02.2020
(51) Int. Cl.: D06M 14/20

(54) **COATINGS**

(30) Priority: 22.02.2019 GB 201902460; 30.01.2020 GB 202001282
(71) Applicant: P2i Ltd, Milton Park Abingdon Oxfordshire OX14 4SA (GB)
(72) Inventor: POULTER, Neil, Marlborough, Wiltshire SN8 3LT (GB); FRASER, Rebekah Catherine, Oxford, Oxfordshire OX1 4TA (GB)
(74) Representative: Greaves Brewster LLP

(57) **Abstract**

The present invention relates to a method for forming a polymeric nanocoating on a substrate as well as substrates bearing the polymeric nanocoating. The method comprises exposing the substrate to a plasma comprising one or more unsaturated monomeric species for a period of time sufficient to allow the coating to form on the substrate. The one or more unsaturated monomeric species comprise (i) an aromatic moiety and (ii) a carbonyl moiety. The one or more unsaturated monomeric species also comprise a crosslinking reagent.

## Description

### TECHNICAL FIELD

This invention relates to coatings. In particular, though not exclusively, the invention relates to substrates bearing coatings, as well as methods for forming coatings on substrates.

### BACKGROUND

There are many circumstances in which it can be advantageous to protect a substrate by applying a protective coating. For example, it may be desirable to protect a substrate from damage caused by moisture, dust, chemicals or temperature extremes, and in particular from contamination by liquids such as water.

It is known to apply protective coatings to substrates by wet chemistry techniques, such as brushing, spraying and dipping. Conformal coatings take the 3D shape of the substrate on which they are formed and cover the entire surface of the substrate. For example, it is known to apply relatively thick protective coatings to electronic substrates based on parylene technology. A conformal coating formed in this way typically has a thickness of 30-130 µm for an acrylic resin, epoxy resin or urethane resin and 50-210 µm for a silicone resin.

An alternative approach has been to form water repellent coatings via plasma polymerisation processes using perfluoroalkyl chain monomers (see e.g. WO 9858117). This technique has allowed relatively thinner coatings to be formed, which derive their water repellence from the presence of the fluorocarbons.

However, the fluorocarbons used in such coatings have a detrimental environmental impact. In addition, fluorocarbon chemistry results in HF being produced as a by-product of the coating deposition process, contributing towards reduced safety of the processes and increased cost of exhaust gas abatement.

There remains a need in the art for highly effective protective coatings without the disadvantages of coatings applied by prior art methods. Such coatings could further enhance the resistance of substrates to e.g. liquids, enhance durability, enable more efficient manufacture of protected substrates, and/or improve the environmental impact of the manufacture processes. It is an object of the invention to provide a solution to this problem and/or at least one other problem associated with the prior art.

### SUMMARY OF THE INVENTION

A first aspect of the invention provides a substrate bearing a polymeric nanocoating, wherein the coating comprises (i) aromatic moieties and (ii) carbonyl moieties.

A second aspect of the invention provides a method for forming a polymeric nanocoating on a substrate, the method comprising exposing the substrate to a plasma comprising one or more unsaturated monomeric species for a period of time sufficient to allow the coating to form on the substrate, wherein the one or more unsaturated monomeric species comprise (i) an aromatic moiety and (ii) a carbonyl moiety.

A third aspect of the invention provides a substrate bearing a polymeric nanocoating, wherein the coating is obtainable by the method according to the second aspect of the invention.

### DETAILED DESCRIPTION

Aspects of the present invention relate to a substrate bearing a polymeric nanocoating and a method for forming a polymeric nanocoating. The method for forming the nanocoating uses unsaturated monomeric species comprising aromatic moieties and carbonyl moieties, and the nanocoating comprises aromatic moieties and carbonyl moieties.

It has been found that nanocoatings provided by the invention can offer desirable barrier properties and durability. Without wishing to be bound by theory, it is thought that: (i) the presence of aromatic moieties, due to their planar structure, can contribute to an advantageously high density of the coatings in combination with relative chemical inertness and low polarity (and is thus associated with enhanced barrier properties); and (ii) the presence of carbonyl can assist radical polymerisation and facilitate low-energy polymerisation, avoiding fragmentation at higher energies which can reduce barrier coating quality.

The presence of the aromatic moieties and carbonyl moieties can be determined using methods which are well-known in the art, such as for example FTIR/ATR. FTIR/ATR can for example indicate the presence of Ar-H and C=O stretches.

The coating is a polymeric nanocoating. Generally, a nanocoating may have a thickness of 15,000 nm or less. Coatings with a thickness of 15,000 nm or less can, for example, be prepared by using a plasma deposition process.

In an embodiment, the coating has a thickness of 10,000 nm or less, or 1000 nm or less. In an embodiment, the coating has a thickness of 1 nm or more, or 50 nm or more.

The coating may for example have a thickness of from 1 to 15,000 nm, or from 50 to 10,000 nm, optionally from 50 to 8000 nm, from 100 to 5000 nm, from 250 nm to 5000 nm, or from 250 nm to 2000 nm.

In an embodiment, the thickness of the coating is from 1 nm, 5 nm, 10 nm, 20 nm, 30 nm, 40 nm,50 nm, 100 nm, 250 nm, 500nm, 750nm, 1000 nm, 1100 nm, 1200 nm, 1300 nm, 1400 nm, 1500 nm, 1600 nm, 1700nm, 1800 nm, 1900 nm, 2000 nm, 2100 nm, 2200 nm, 2300 nm, 2400 nm or 2500nm, and/or the thickness of the coating is up to 15000 nm, 14000 nm, 13000 nm, 12000 nm, 11000 nm, 10000nm, 9000nm, 8000nm, 7000nm, 6000 nm, 5500 nm, 5000 nm, 4900 nm, 4800 nm, 4700 nm, 4600 nm, 4500 nm, 4400 nm, 4300 nm, 4200 nm, 4100 nm, 4000 nm, 3900 nm, 3800 nm, 3700 nm, 3600 nm, 3500 nm, 3400 nm, 3300 nm, 3200 nm, 3100 nm, 3000 nm, 2900 nm, 2800 nm, 2700 nm, 2600 nm, 2500 nm, 2400 nm, 2300 nm, 2200 nm, 2100 nm, 2000 nm or 1900 nm.

The thickness of a coating may be determined by spectroscopic reflectometry, optionally using optical constants verified for example by spectroscopic ellipsometry, for example as set out below.

Preferably, the coating may be substantially free from fluorine. The absence of fluorine provides improved environmental properties, and improved safety and potentially decreased cost of exhaust gas abatement during the manufacturing process. In an embodiment, the coating is substantially free from halogens.

Preferably, the coating may be a protective layer, which for example prevents damage by contact with water or other liquids.

In an embodiment, the coating may be a barrier coating which can function as a physical barrier, for example by providing a physical barrier to mass and/or electron transport. In an embodiment, the coating restricts diffusion of water, oxygen and ions. In an embodiment, the coating provides electrical resistance.

In an embodiment, the coating is substantially pin-hole free. Preferably ΔZ/d <0.15, where ΔZ is the average height variation on an AFM line scan in nm and d is coating thickness in nm.

The value of ΔZ/d tells us to what extent defects/voids on the surface of the coating extend into the coating, i.e. the percentage value of the depth of defect over total coating thickness. For example, ΔZ/d = 0.15 means that the voids on the surface only extend down to a maximum of 15% of the coating thickness. A coating with a ΔZ/d <0.15 is defined herein as being substantially pinhole free. If voids are bigger than this, the desired functionality is unlikely to be achieved.

The coating is preferably conformal, which can mean that it takes the 3D shape of the substrate and covers substantially an entire surface of the substrate. This has the advantage of ensuring that the coating has sufficient thickness to give optimal functionality over an entire surface of the substrate. The meaning of the term "covers substantially an entire surface" will depend to some extent on the type of surface to be covered. For example, for some substrates, it may be necessary for there to be complete coverage of the surface in order for the substrate to perform its function, e.g. after submersion in water. However, for other components or housings, small gaps in coverage may be tolerated.

The substrate which bears the polymeric nanocoating, or on which the polymeric nanocoating is formed, can, for example, be an electronic device or a component thereof.

It is well known that electronic and electrical devices are very sensitive to damage caused by contamination by liquids such as environmental liquids, in particular water. Contact with liquids, either in the course of normal use or as a result of accidental exposure, can lead to short circuiting between electronic components and irreparable damage to circuit boards, electronic chips etc.

In an embodiment, the substrate is an electronic device or a component thereof. The electronic device can, for example, be selected from the group of small portable electronic equipment such as mobile phones, smartphones, pagers, radios, hearing aids, laptops, notebooks, tablet computers, phablets and personal digital assistants (PDAs). These devices can be exposed to significant liquid contamination when used outside or inside in close proximity of liquids. Such devices are also prone to accidental exposure to liquids, for example if dropped in liquid or splashed.

In another embodiment, the electronic device can, for example, be selected from the group of outdoor lighting systems, radio antenna and other forms of communication equipment.

Throughout this specification, unless expressly stated otherwise, the term "aromatic moiety" encompasses the terms "aryl group", "heteroaryl group", "arylene group" and "heteroaryl group".

Generally, the aromatic moiety is an optionally substituted aromatic moiety.

In an embodiment, the optionally substituted aromatic moiety is an optionally substituted monocyclic aromatic moiety or an optionally substituted bicyclic aromatic moiety. The optionally substituted aromatic moiety may for example contain from 3 to 12 carbon atoms.

The optionally substituted aromatic moiety may be an aryl group, such as a monocyclic or bicyclic aryl group. The optionally substituted aromatic moiety may be a C₃-C₁₂ aryl group, a C₅-C₁₂ aryl group, a C₅-C₁₀ aryl group, a C₅-C₈ aryl group, or a C₅-C₆ aryl group.

In an embodiment, the optionally substituted aromatic moiety does not contain heteroatoms. Preferably, the optionally substituted aromatic moiety is an optionally substituted phenyl group. The phenyl group may be unsubstituted or may be substituted with one or more substituents; the substituents may for example be selected from one or more alkyl groups. The one or more alkyl groups may, for example, be selected from methyl, ethyl, n-propyl, isopropyl, n-butyl, isobutyl, tert-butyl, sec-butyl, n-pentyl, neopentyl, n-hexyl, isohexyl, and 3-methylpentyl.

In another embodiment, the optionally substituted aromatic moiety contains heteroatoms. The optionally substituted aromatic moiety may be an optionally substituted heteroaryl group, such as a monocyclic or bicyclic heteroaryl group. The optionally substituted heteroaryl group may contain from 1 to 12 carbon atoms and one or more N, O or S atoms. The heteroaryl group may be a 5 or 6-membered ring containing one or more N atoms.

The optionally substituted aromatic moiety may be an arylene group, such as a monocyclic or bicyclic arylene group. The optionally substituted aromatic moiety may be a C₃-C₁₂ arylene group, a C₅-C₁₂ arylene group, a C₅-C₁₀ arylene group, a C₅-C₈ arylene group, or a C₅-C₆ arylene group.

In an embodiment, the optionally substituted aromatic moiety does not contain heteroatoms. Preferably, the optionally substituted aromatic moiety is an optionally substituted phenylene group. The phenylene group may be unsubstituted or may be substituted with one or more substituents; the substituents may for example be selected from one or more alkyl groups. The one or more alkyl groups may, for example, be selected from methyl, ethyl, n-propyl, isopropyl, n-butyl, isobutyl, tert-butyl, sec-butyl, n-pentyl, neopentyl, n-hexyl, isohexyl, and 3-methylpentyl.

In another embodiment, the optionally substituted aromatic moiety contains heteroatoms. The optionally substituted aromatic moiety may be an optionally substituted heteroarylene group, such as a monocyclic or bicyclic heteroarylene group. The optionally substituted heteroarylene group may contain from 1 to 12 carbon atoms and one or more N, O or S atoms. The heteroarylene group may be a 5 or 6-membered ring containing one or more N atoms.

Throughout this specification, unless expressly stated otherwise:
- An "optionally substituted" group may be unsubstituted, or substituted with one or more, for example one or two, substituents. These substituents may, for example, be selected from alkyl, cycloalkyl, alkenyl, alkynyl, aryl, heteroaryl and heterocyclyl groups; carboxylic acids and carboxylate ions; carboxylate esters; carbamates; alkoxyl groups; ketone and aldehyde groups; amine and amide groups; -OH; -CN;-NO₂; and halogens.
- An alkyl group may be a straight or branched chain alkyl group. The alkyl group may be C₁ to C₂₇ alkyl, C₁ to C₂₀ alkyl, C₁ to C₁₂ alkyl, C₁ to C₁₀ alkyl, C₁ to C₈ alkyl, C₁ to C₆ alkyl, C₁ to C₅ alkyl, C₁ to C₄ alkyl, C₁ to C₃ alkyl, or C₁ to C₂ alkyl. The alkyl group may, for example, be selected from methyl, ethyl, n-propyl, isopropyl, n-butyl, isobutyl, tert-butyl, sec-butyl, n-pentyl, neopentyl, n-hexyl, isohexyl, and 3-methylpentyl.
- A cycloalkyl group may be C₃ to C₈ cycloalkyl, C₃ to C₇ cycloalkyl, C₃ to C₆ cycloalkyl, C₄ to C₆ cycloalkyl, or C₅ to C₆ cycloalkyl.
- An alkylene group may be a straight or branched chain alkylene group. The alkylene group may be C₁ to C₂₇ alkylene, C₁ to C₂₀ alkylene, C₁ to C₁₂ alkylene, C₁ to C₁₀ alkylene, C₁ to C₈ alkylene, C₁ to C₆ alkylene, C₁ to C₅ alkylene, C₁ to C₄ alkylene, C₁ to C₃ alkylene, or C₁ to C₂ alkylene.
- A halogen group may be fluorine (F), chlorine (CI), bromine (Br), or iodine (I); preferably fluorine (F).

The one or more monomeric species are unsaturated.

The use of unsaturated monomeric species allows the use of lower activation energies than would be required for saturated monomeric species. This helps to avoid fragmentation of the monomeric species during the plasma process, giving better structural retention and improved barrier coating quality.

The one or more unsaturated monomeric species may comprise a monomer compound which is unsaturated and comprises (i) an aromatic moiety and (ii) a carbonyl moiety.

The aromatic moiety may be an optionally substituted aromatic moiety as defined above.

In an embodiment, the monomer compound comprises moiety A or B: 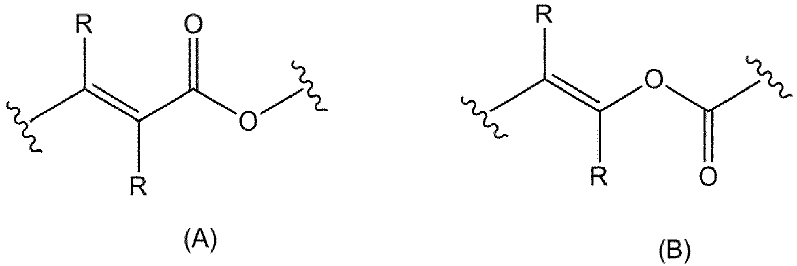 wherein each R is independently selected from hydrogen, halogen, optionally substituted branched or straight chain alkyl (e.g. C₁-C₆ alkyl), or optionally substituted cycloalkyl (e.g. C₃-C₈ cycloalkyl).

In these embodiments, the carbonyl moiety (ii) forms part of moiety A or B.

The functionalities in moieties A and B, which can include e.g. an acrylate moiety or a vinyl ester moiety, can stabilise radicals during polymerisation.

Suitably, the monomer compound can comprise (i) an aromatic moiety which is linked to (ii) a moiety capable of assisting radical polymerisation comprising a carbonyl moiety. The moiety capable of assisting radical polymerisation may also be capable of facilitating low-energy polymerisation. The moiety capable of assisting radical polymerisation can be linked to the aromatic moiety either directly or via a linker moiety. Preferably, the moiety capable of assisting radical polymerisation is moiety A or B as defined above.

Preferably, the monomer compound is a compound of formula (I):

Q-Z-Ar (I)

wherein
Q is selected from structures (Qa) and (Qb): 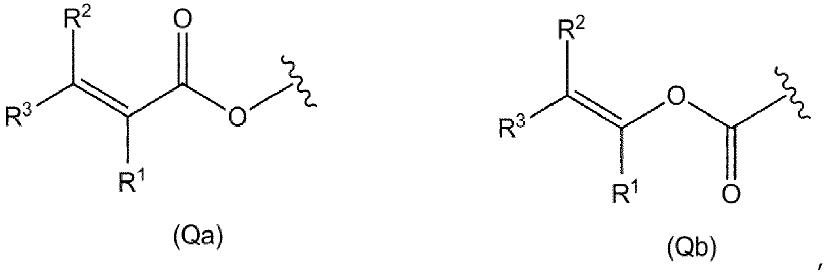 wherein each of R¹, R² and R³ is independently selected from hydrogen, optionally substituted branched or straight chain C₁-C₆ alkyl, or optionally substituted C₃-C₈ cycloalkyl;
Z is a direct bond or a linker moiety; and
Ar is an optionally substituted aromatic moiety.

In an embodiment, each of R¹, R² and R³ is independently selected from hydrogen, methyl, ethyl, n-propyl, isopropyl, n-butyl, isobutyl, tert-butyl, sec-butyl, n-pentyl, neopentyl, n-hexyl, isohexyl, and 3-methylpentyl. In an embodiment, each of R¹, R² and R³ is independently selected from hydrogen, methyl and ethyl. In an embodiment, each of R¹, R² and R³ is independently selected from hydrogen or methyl.

In an embodiment, R¹ and R² are both hydrogen. In an embodiment, R¹ and R³ are both hydrogen. In an embodiment, R² and R³ are both hydrogen. In an embodiment, each of R¹, R² and R³ is hydrogen.

In an embodiment, Q is structure (Qa) as defined above. In an embodiment, Q is structure (Qb) as defined above.

When Q is structure (Qa), the monomer compound is a compound of formula (Ia): 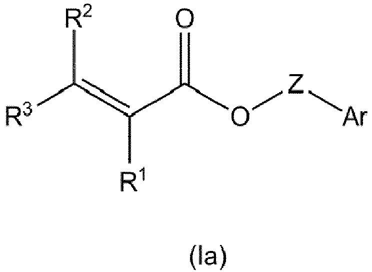 wherein R¹, R², R³, Z and Ar are as defined above.

In an embodiment, the compound of formula (Ia) is selected from benzyl acrylate, phenyl acrylate and 2-phenylethyl acrylate. Preferably, the compound of formula (Ia) is benzyl acrylate.

When Q is structure (Qb), the monomer compound is a compound of formula (Ib): 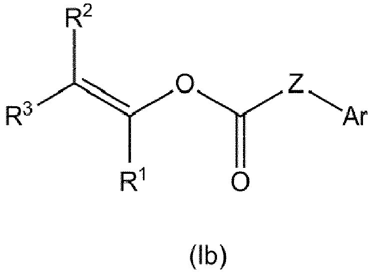 wherein R¹, R², R³, Z and Ar are as defined above.

In formulae (I), (Ia) and (Ib), Ar represents an optionally substituted aromatic moiety. The optionally substituted aromatic moiety can be as defined above.

In formulae (I), (Ia) and (Ib), Z represents a direct bond or a linker moiety.

In an embodiment, Z is a direct bond.

In an embodiment, Z is a linker moiety. Suitably, Z may be an optionally substituted alkylene group, such as for example a C₁-C₂₇ alkylene, which is unsubstituted or substituted by one or more substituents which may e.g. be selected from hydroxy, C₁-C₁₂ alkoxy, C₁-C₁₂ alkyl, hydroxy-C₁-C₁₂-alkyl and halogen. In an embodiment, one to ten carbon atoms in the alkylene chain are replaced by spacer moieties selected from C₂-C₆ alkenylene, -O-, -S-, and -NR"-, wherein R" is selected from hydrogen, optionally substituted branched or straight chain C₁-C₆ alkyl, or optionally substituted C₃-C₈ cycloalkyl. In an embodiment, the alkylene group comprises 1, 2, 3, 4 or 5 spacer moieties. In an embodiment, the alkylene group comprises 1 to 3 spacer moieties. In an embodiment, the alkylene group comprises 1 or 2 spacer moieties.

In an embodiment, the alkylene group is a C₁-C₂₀ alkylene. In an embodiment, the alkylene group is a C₁-C₁₀ alkylene, such as a C₁-C₆ alkylene. In an embodiment, the alkylene is a straight chain alkylene.

In an embodiment, the alkylene is substituted by one or more substituents. In an embodiment, the alkylene group is unsubstituted.

In an embodiment, Z has the formula:

-(CH₂)ₙ-

where n is an integer from 0 to 27.

When n is 0, Z is a direct bond. When n is 1 or more, Z is a linker moiety.

In an embodiment, the lower value of the possible range for n is 0, 1, 2, 3, 4, 5, 6, 7, 8, 9, 10, 11, 12, 13, 14, 15, 16, 17, 18, 19, 20, 21, 22, 23, 24, 25 or 26 and/or the upper value of the possible range for n is 27, 26, 25, 24, 23, 22, 21, 20, 19, 18, 17, 16, 15, 14, 13, 12, 11, 10, 9, 8, 7, 6, 5, 4, 3 or 2. In an embodiment, n is an integer from 0 to 2, or n is 1 or 2. Preferably, n is 1.

In formulae (I), (Ia) and (Ib), Ar is an optionally substituted aromatic moiety. The optionally substituted aromatic moiety is as defined above.

In a preferred embodiment, the monomer compound does not contain any fluorine atoms. Optionally, the monomer compound does not contain any halogen atoms.

The one or more unsaturated monomeric species may comprise a crosslinking reagent.

Optionally, the one or more unsaturated monomeric species may further comprise a crosslinking reagent, in addition to the monomer compound as defined above.

In an embodiment, the one or more unsaturated monomeric species comprise the monomer compound as defined above and optionally the crosslinking reagent.

In an embodiment, the crosslinking reagent comprises (i) an aromatic moiety and (ii) a carbonyl moiety.

Generally, the crosslinking reagent can comprise two or more unsaturated bonds attached by means of one or more linker moieties.

In an embodiment, the crosslinking reagent has a boiling point of less than 500 °C at standard pressure.

In an embodiment, the crosslinking reagent is independently selected from a compound of formula (II) or (III): 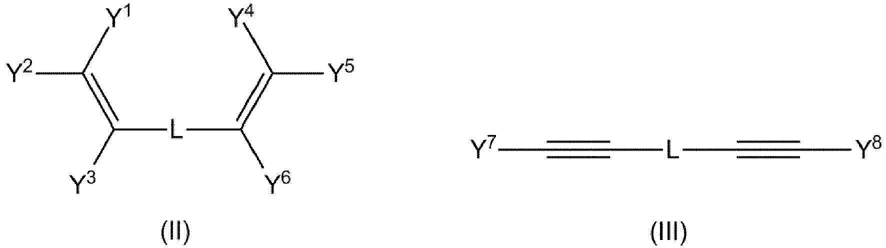 wherein
Y¹, Y², Y³, Y⁴, Y⁵, Y⁶, Y⁷ and Y⁸ are each independently selected from hydrogen, optionally substituted branched or straight chain C₁-C₆ alkyl, optionally substituted C₁-C₆ cycloalkyl, and optionally substituted C₁-C₆ aryl; and
L is a linker moiety.

In an embodiment, L contains an aromatic moiety and a carbonyl moiety.

In an embodiment, L has the formula: 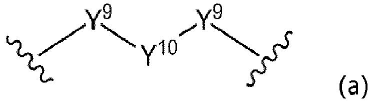 wherein
each Y⁹ is independently selected from a bond, -O-, -O-C(O)-, -C(O)-O-, -Y¹¹-O-C(O)-, -C(O)-O-Y¹¹-, -O-C(O)-Y¹¹-, -Y¹¹-C(O)-O-, -OY¹¹-, and -Y¹¹O-, wherein Y¹¹ is an optionally substituted branched, straight chain or cyclic C₁-C₈ alkylene; and
Y¹⁰ is selected from an optionally substituted branched, straight chain or cyclic C₁-C₈ alkylene, arylene, and a siloxane group.

In an embodiment, each Y⁹ is a bond.

In an embodiment, each Y⁹ is -O-.

In an embodiment, each Y⁹ is a vinyl ester or vinyl ether group.

In an embodiment, Y¹⁰ has the formula: 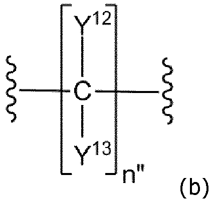 wherein each Y¹² and Y¹³ is independently selected from hydrogen, halogen, optionally substituted cyclic, branched or straight chain C₁-C₈ alkyl, or -OY¹⁴, wherein Y¹⁴ is selected from optionally substituted branched or straight chain C₁-C₈ alkyl or alkenyl, and n" is an integer from 1 to 10.

In an embodiment, each Y¹² is hydrogen and each Y¹³ is hydrogen, such that Y¹⁰ is a linear alkylene chain. For this embodiment, Y⁹ can for example be a vinyl ester or vinyl ether group.

In an embodiment, each Y¹² is fluoro and each Y¹³ is fluoro, such that Y¹⁰ is a linear perfluoroalkylene chain.

n" is an integer from 0 to 10. In an embodiment, the lower value of the possible range for n" is 0, 1, 2, 3, 4, 5, 6, 7, 8 or 9 and/or the upper value of the possible range for n" is 10, 9, 8, 7, 6, 5, 4, 3, 2 or 1. In an embodiment, n" is from 4 to 6.

In an embodiment, Y¹⁰ has the formula: 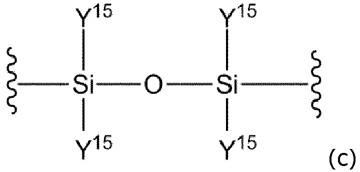 wherein each Y¹⁵ is independently selected from optionally substituted branched or straight chain C₁-C₆ alkyl.

In an embodiment, each Y¹⁵ is methyl. In an embodiment, each Y⁹ is a bond.

In an embodiment, Y¹⁰ has the formula: 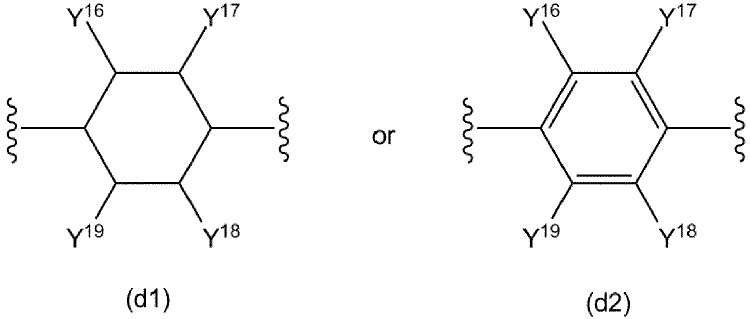 wherein Y¹⁶, Y¹⁷, Y¹⁸ and Y¹⁹ are each independently selected from hydrogen and optionally substituted branched or straight chain C₁-C₈ alkyl or alkenyl. In an embodiment, the alkenyl group is vinyl.

In an embodiment, Y¹⁸ is hydrogen or vinyl, and Y¹⁶, Y¹⁷ and Y¹⁹ are each hydrogen. In an embodiment, each of Y¹⁶, Y¹⁷, Y¹⁸ and Y¹⁹ is hydrogen. In another embodiment Y¹⁸ is vinyl, and Y¹⁶, Y¹⁷ and Y¹⁹ are each hydrogen.

In an embodiment, group L has one of the following structures:

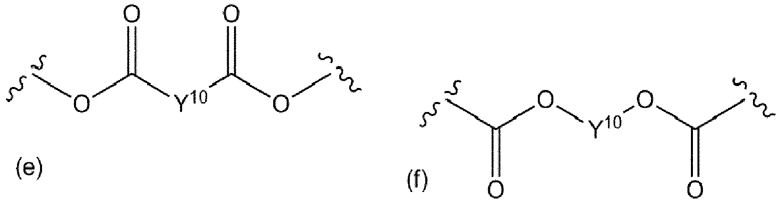

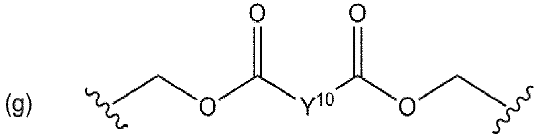

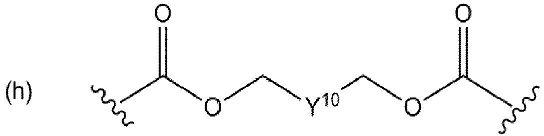

In an embodiment, group L has one of the following structures:

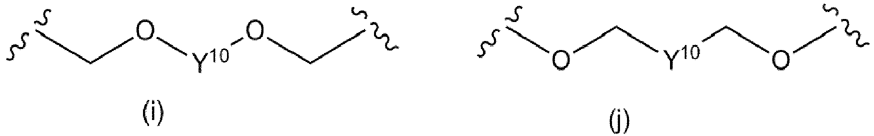

For L according structure (e), Y¹⁰ can for example be an alkylene chain or a cycloalkylene, such as those shown in structures (b) and (d) above. The alkylene chain may for example be a straight chain alkylene chain.

When Y¹⁰ is a cycloalkylene, this can for example be cyclohexylene, such as 1,4-cyclohexylene.

For L according to structure (f), Y¹⁰ can for example be structure (b), e.g. an alkylene chain, or structure (d1) or structure (d2).

For L according to structure (g), Y¹⁰ can for example be a cycloalkylene, such as the cyclohexylene according to structure (d1).

For L according to structure (h), Y¹⁰ can for example be structure (b).

For L according to structure (i) or structure (j), Y¹⁰ can for example be alkylene or cycloalkylene. Optionally the alkylene or cycloalkylene may be substituted with one or more vinyl groups or alkenyl ether groups, for example one or more vinyl ether groups.

When each Y⁹ is a bond, each Y¹⁰ may for example be any of structures (b), (c), (d1) and (d2).

In an embodiment Y¹⁰ is a straight chain alkylene such that the crosslinking reagent is a diene, such as for example a heptadiene, octadiene, or nonadiene; in an embodiment it is 1,7-octadiene.

When each Y⁹ is O, each Y¹⁰ may for example be a branched or straight chain C₁-C₆ alkylene, preferably a straight chain alkylene, most preferably a C₄ straight chain alkylene. In an embodiment the crosslinking reagent is 1,4-butanediol divinyl ether.

It will be understood that each Y⁹ group can be combined with any other Y⁹ group and Y¹⁰ group to form the crosslinking reagent.

The skilled person will be aware of possible substituents for each of the cyclic, branched or straight chain C₁-C₈ alkylene groups mentioned above. The alkylene groups may be substituted at one or more positions by a suitable chemical group. Each C₁-C₈ alkylene group may for example be a C₁-C₃, C₂-C₆, or C₆-C₈ alkylene group.

In an embodiment, the crosslinking reagent has alkyl chains for Y¹⁰ and vinyl ester or vinyl ether groups on either side.

In a preferred embodiment, the crosslinking reagent does not contain any fluorine atoms. Optionally, the monomer compound does not contain any halogen atoms.

In an embodiment, the crosslinking reagent is independently selected from divinyl adipate (DVA), 1,4-butanediol divinyl ether (BDVE), 1,4-cyclohexanedimethanol divinyl ether (CDDE), 1,7-octadiene (170D), 1,2,4-trivinylcyclohexane (TVCH), 1,3-divinyltetramethyldisiloxane (DVTMDS), diallyl 1,4-cyclohexanedicarboxylate (DCHD), glyoxal bis(diallyl acetal) (GBDA) and 1,4-phenylene diacrylate.

In an embodiment, the crosslinking reagent is divinyl adipate (DVA).

In an embodiment, the crosslinking reagent is 1,4-butanediol divinyl ether (BDVE).

In an embodiment, for the compound of formula (III), group L can for example be selected from a branched or straight chain C₁-C₈ alkylene or an ether group. L may for example be a C₃, C₄, C₅, or C₆ alkylene, preferably a straight chain alkylene.

Chemical structures of crosslinking reagents are set out below in Table 1.

**Table 1: Crosslinking reagents**

| | |
|---|---|
| Divinyl Adipate (DVA) | 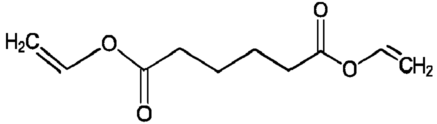 |
| 1,4 Butanediol divinyl ether (BDVE) | 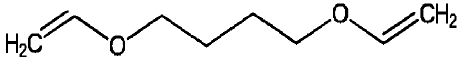 |
| 1,4 Cyclohexanedimethanol divinyl ether (CDDE) | 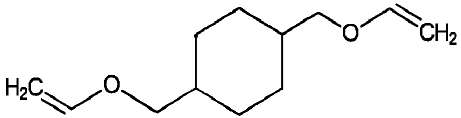 |
| 1,7 -Octadiene (17OD) | 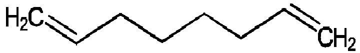 |
| 1,2,4 -Trivinylcyclohexane (TVCH) | 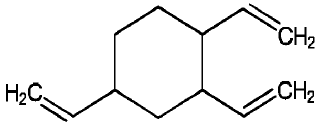 |
| 1,3-Divinyltetramethyldisiloxane (DVTMDS) | 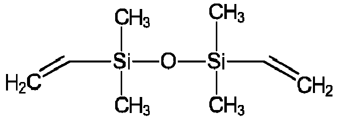 |
| Diallyl 1,4-cyclohexanedicarboxylate (DCHD) | 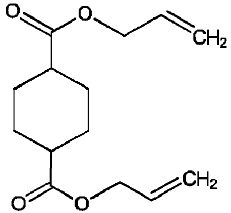 |
| 1,4-Phenylene diacrylate | 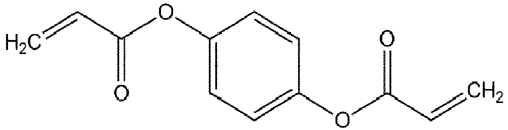 |
| GBDA | 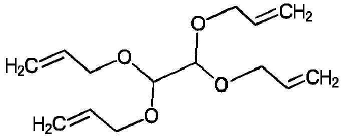 |
| 1,6-heptadiyne | 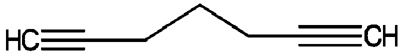 |
| 1,7-heptadiyne | 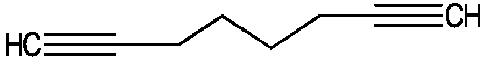 |
| 1,8-heptadiyne | 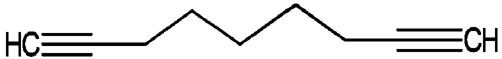 |
| Propargyl ether | 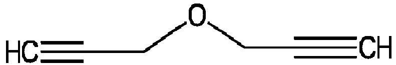 |

In general, in a plasma deposition process an item to be treated is placed in a plasma deposition chamber, a glow discharge is ignited within said chamber, and a suitable voltage is applied, which may be either continuous wave or pulsed. The glow discharge is suitably ignited by applying a high frequency voltage, for example at 13.56MHz.

Before the monomeric species enter the deposition chamber each may be in the form of a gas, liquid or a solid (for example a powder) at room temperature. However, it is preferred that the one or more monomeric species, which can include the monomer compound and/or the crosslinking reagent, are liquid at room temperature.

In an embodiment, the one or more monomeric species, which can include the monomer compound and/or the crosslinking reagent, are introduced to a plasma deposition chamber in the liquid phase.

When both the monomer compound and the crosslinking reagent are present, the crosslinking reagent may be miscible with the monomer compound. They can be introduced together or separately into the plasma chamber. Or the crosslinking reagent may be immiscible with the monomer compound and introduced separately into the plasma chamber. In this context, the term "miscible" means that the crosslinking reagent is soluble in the monomer compound, and when mixed they form a solution of uniform composition. The term "immiscible" is used to mean that the crosslinking reagent is only partly soluble or insoluble in the monomer compound, and so either forms an emulsion or separates out into two layers.

The one or more monomeric species will suitably be in a gaseous state in the plasma. The plasma may simply comprise a vapour of the monomeric species. Such a vapour may be formed in-situ, with the monomeric species being introduced into the chamber in liquid form. The monomeric species may also be combined with a carrier gas, in particular, an inert gas such as helium or argon.

In preferred embodiments, the one or more monomeric species may be delivered into the chamber by way of an aerosol device such as a nebuliser or the like, as described for example in WO 2003/097245 and WO 2003/101621. In such an arrangement a carrier gas may not be required, which advantageously assists in achieving high flow rates.

The exact flow rate of the one or more monomeric species into the chamber may depend to some extent on the nature of the particular monomeric species being used, the nature of the substrate, the desired coating properties, and the plasma chamber volume. In some embodiments of the invention, the one or more monomeric species are introduced into the chamber at a gas flow rate of at least 1 sccm (standard cubic centimetre per minute) and preferably in the range of from 1 to 2500 sccm. In an embodiment, the one or more monomeric species are introduced into the chamber at a gas flow rate of from 1 sccm, 5 sccm, 10 sccm, 15 sccm, 20 sccm, 25 sccm, 30 sccm, 35 sccm, 40 sccm, 45 sccm, 50 sccm, 100 sccm, 150 sccm, 200 sccm, or 250 sccm, and/or up to 2500 sccm, 2000 sccm, 1500 sccm, 1000 sccm, 750 sccm, 500 sccm, 250 sccm, 200 sccm, 100 sccm or 60 sccm.

The monomeric species gas flow can be calculated from the liquid monomer flow, for example by using the ideal gas law, i.e. assuming that the monomeric species in the chamber act like an ideal gas where one mole of gas at 273 K and 1 atmospheric pressure (STP) occupies a volume of 22400 cm³.

The step of exposing a substrate to a plasma may comprise a pulsed (PW) deposition step. Alternatively, or in addition, the step of exposing a substrate to a plasma may comprise a continuous wave (CW) deposition step.

The term pulsed may mean that the plasma cycles between a state of no (or substantially no) plasma emission (off-state) and a state where a particular amount of plasma is emitted (on-state). Alternatively, pulsed may mean that there is continuous emission of plasma but that the amount of plasma cycles between an upper limit (on-state) and lower limit (off-state).

For pulsed plasmas, higher average powers can be achieved by using higher peak powers and varying the pulsing regime (i.e. on/off times).

Optionally the voltage is pulsed in a sequence in which the ratio of the time on/time off is in the range of from 0.001 to 1, optionally 0.002 to 0.5. For example, time on may be 10-500 µs, or 35-45 µs, or 30-40 µs, such as about 36 µs; and time off may be from 0.1 to 30 ms, or 0.1 to 20 ms, or 5 to 15 ms, for example 6ms. Time on may be 35 µs, 40 µs, 45 µs. Time off may be 0.1, 1, 2, 3, 6, 8, 10, 15, 20, 25 or 30 ms.

Optionally the voltage is applied as a pulsed field for a period of from 30 seconds to 90 minutes. Optionally the voltage is applied as a pulsed field for from 5 to 60 minutes.

The RF power can be supplied from 1 to 2000 W, for example from 50 to 1000 W, from 100 to 500 W, from 125 to 250 W.

The peak power can be from 1 to 2000 W, for example from 50 to 1000 W, from 100 to 500 W, from 125 to 250 W, or about 160 W. In an embodiment, the peak power is from 1 W, 50 W, 100 W, 125 W, 150 W, 200 W, 300 W, 400 W or 500 W, and/or up to 10 kW, 5000 W, 4000 W, 3000 W, 2000 W, 1000 W, 900 W, 800 W, 700 W, 600 W, 500 W, 400 W, 300 W, 250 W or 200 W.

The peak power to monomer flow ratio for a continuous wave plasma or a pulsed plasma may be from 2 to 60 W/sccm, from 2 to 40 W/sccm, from 2 to 25 W/sccm, or from 5 to 20 W/sccm. In an embodiment, the peak power to monomer flow ratio is from 0.1 W/sccm, 0.5 W/sccm, 0.6 W/sccm, 0.7 W/sccm, 0.8 W/sccm, 0.9 W/sccm, 1 W/sccm, 2 W/sccm, 3 W/sccm, 4 W/sccm or 5 W/sccm, and/or up to 40 W/sccm, 39 W/sccm, 38 W/sccm, 35 W/sccm, 30 W/sccm, 25 W/sccm, 20 W/sccm, 15 W/sccm, 10 W/sccm, 9 W/sccm, 8 W/sccm, 7 W/sccm, 6 W/sccm, 5 W/sccm, 4 W/sccm, 3 W/sccm or 2 W/sccm.

During exposure of a substrate to a continuous wave plasma or a pulsed plasma, the plasma can have a peak power density of from 0.001 to 40 W/litre, or at least 2 W/litre, or about 20 W/litre. In an embodiment, the peak power density is from 0.001 W/litre, 0.01 W/litre, 0.1 W/litre, 0.2 W/litre, 0.3 W/litre, 0.4 W/litre, 0.5 W/litre, 0.6 W/litre, 0.7 W/litre, 0.8 W/litre, 0.9 W/litre, 1 W/litre, 2 W/litre, 3 W/litre, 4 W/litre, 5 W/litre, 10 W/litre, 15 W/litre or 20 W/litre, and or up to 25 W/litre, 20 W/litre, 15 W/litre, 10 W/litre, 5 W/litre, 4 W/litre, 3 W/litre or 2W/litre.

When both the monomer compound and the crosslinking reagent are present, in an embodiment the volumetric ratio of the crosslinking reagent to the monomer compound is from 0.1:99.9 to 90:10, or from 1:99 to 90:10, or from 1:99 to 50:50, or from 1:99 to 30:70. In an embodiment, the volumetric ratio of the crosslinking reagent to the monomer compound is from 1:99 to 25:75, from 1:99 to 20:80, from 5:95 to 20:80, or from 5:95 to 15:85. In an embodiment, the volumetric ratio of the crosslinking reagent to the monomer compound is about 10:90.

In an embodiment, the volumetric ratio of the crosslinking reagent to the monomer compound is from 0.1:99.9, 1:99, 2:98, 3:97, 4:96, 5:95, 6:96, 7:93, 8:92, 9:91 or 10:90, and/or the volumetric ratio of the crosslinking reagent to the monomer compound is up to 90:10, 80:20, 70:30, 60:40, 50:50, 40:60, 30:70, 29:71, 28:72, 27:73, 26:74, 25:75, 24:76, 23:77, 22:78, 21:79, 20:80, 19:81, 18:82, 17:83, 16:84, 15:85, 14:86, 13:87, 12:88, 11:89 or 10:90.

As would be known to a skilled person, it is common in the art of plasma deposition to use the measurement of volumetric ratio when introducing reagents into a plasma deposition chamber. Alternatively, the ratio between reagents such as monomer compounds and crosslinking reagents can be expressed as the molar ratio at which reagents are introduced into the chamber. This is known as the molar input flow ratio.

In an embodiment, the monomer compound and the crosslinking reagent are introduced to a plasma deposition chamber, optionally in the liquid phase, and the molar input flow ratio of the crosslinking reagent to the monomer compound is from 1:20 to 10:1, or from 1:20 to 1:1. In an embodiment, the molar input flow ratio of the crosslinking reagent to the monomer compound is from 1:20 to 1:2, from 1:15 to 1:5, from 1:14 to 1:6, or from 1:20 to 1:6.

In an embodiment, the molar input flow ratio of the crosslinking reagent to the monomer compound is from 1:20, 1:19, 1:18, 1:17, 1:16, 1:15, 1:14, 1:13, 1:12, 1:11, 1:10, 1:9, 1:8, 1:7, 1:6, 1:5, 1:4, 1:3 or 1:2, and/or the molar input flow ratio of the possible range for the crosslinking reagent to the monomer compound is up to 10:1, 9:1, 8:1, 7:1, 6:1, 5:1, 4:1, 3:1, 2:1, 1:1, 1:2, 1:3, 1:4, 1:5, 1:6, 1:7, 1:8, 1:9, 1:10, 1:11, 1:12, 1:13, 1:14, 1:15, 1:16, 1:17, 1:18 or 1:19.

The volumetric ratio of the crosslinking reagent to the monomer compound can easily be converted to the molar ratio of the crosslinking reagent to the monomer compound and *vice versa* for particular monomer compounds and crosslinking reagents.

For example, when the crosslinking reagent and the monomer compound are introduced to a plasma deposition chamber in the liquid phase and the volumetric ratio of the crosslinking reagent to the monomer compound is 10:90, if the crosslinking reagent is DVA and the monomer compound is benzyl acrylate, the molar input flow ratio of DVA to benzyl acrylate is about 1:8.

Throughout the description, clauses and claims of this specification, the words "comprise" and "contain" and variations of the words, for example "comprising" and "comprises", mean "including but not limited to", and do not exclude other components, integers or steps. Moreover the singular encompasses the plural unless the context otherwise requires: in particular, where the indefinite article is used, the specification is to be understood as contemplating plurality as well as singularity, unless the context requires otherwise.

Preferred features of each aspect of the invention may be as described in connection with any of the other aspects. Within the scope of this application it is expressly intended that the various aspects, embodiments, examples and alternatives set out in the preceding paragraphs, in the clauses, claims and/or in the following description and drawings, and in particular the individual features thereof, may be taken independently or in any combination. That is, all embodiments and/or features of any embodiment can be combined in any way and/or combination, unless such features are incompatible.

One or more embodiments of the invention will now be described, by way of example only, with reference to the accompanying drawings, in which:

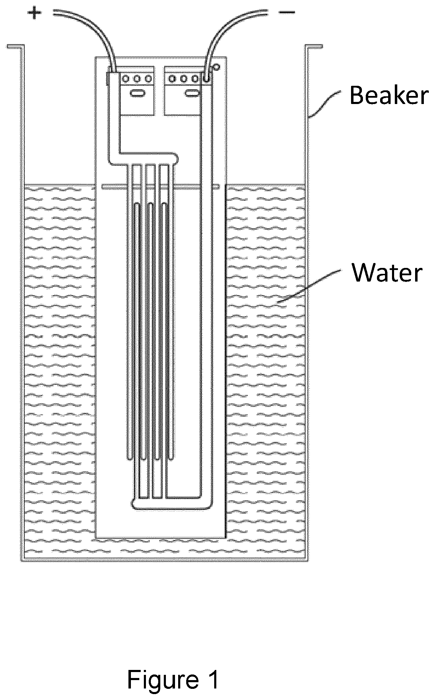

Figure 1 shows electrical test apparatus for determining the resistance of a coating.

### EXAMPLES

### Plasma deposition process

For experiments conducted in a 22 L plasma chamber, plasma polymerization experiments were carried out in a metallic reaction chamber with a working volume of 22 litres. The chamber consisted of two parts, a shallow cuboid cavity with a single open face, oriented vertically, which was sealed to a solid metallic door via a Viton O ring on the outer edge. All surfaces were heated to 37 °C. Inside the chamber was a single perforated metal electrode, area per the open face of the cavity, also oriented vertically and attached via connections at the corners to the door, fed by an RF power unit via a connection through the centre of the metallic door. For pulsed plasma deposition the RF power unit was controlled by a pulse generator.

The rear of the chamber was connected via a larger cavity, achieving a total volume of 125 L, to a metal pump line, pressure controlling valve, a compressed dry air supply and a vacuum pump. The door of the chamber comprised several cylindrical ports for connection to pressure gauges, monomer delivery valves temperature controls and gas feed lines which were in turn connected to mass flow controllers.

In each experiment a sample was positioned vertically on nylon pegs attached to the perforated electrode, facing the door.

The reactor was evacuated down to base pressure (typically < 10 mTorr). Process gas was delivered into the chamber using the mass flow controllers, with typical gas flow values being between 2-25 sccm. The monomer was delivered into the chamber, with typical monomer gas flow values being between 5-100 sccm. The pressure inside the reactor was maintained at between 20-30 mTorr. The plasma was produced using RF at 13.56 MHz. The process usually contains at least the steps of a continuous wave (CW) plasma and a pulsed wave (PW) plasma. Optionally, these steps can be proceeded by an initial activation step using a continuous wave (CW) plasma. The activation CW plasma, if used, was for 1 minute, the CW plasma was for 1 or 4 minutes and the duration of the PW plasma varied in different experiments. The peak power setting was 160 W in each case, and the pulse conditions were time on (tₒₙ) = 37 µs and time off (t_{off}) = 10 ms. At the end of the deposition the RF power was switched off, the monomer delivery valves stopped and the chamber pumped down to base pressure. The chamber was the vented to atmospheric pressure and the coated samples removed.

For each experiment, test printed circuit boards (PCBs) and accompanying Si wafers were used. The Si wafers allow physical properties of the formed coating to be measured, for example AFM for surface morphology and XRR for coating density. The metal tracks of the test PCBs were gold coated copper. The Si wafers were placed on the top front side of the PCBs.

### Analytical methods

A number of properties of exemplary polymeric nanocoatings according to the invention were investigated, using the following methods.

### Resistance in tap water

This test method has been devised to evaluate the ability of different coatings to provide an electrical barrier on printed circuit boards and predict the ability of a smart phone to pass the IEC 60529 14.2.7 (IPX7) test. The method is designed to be used with tap water. This test involves measuring the current voltage (IV) characteristics of a standardised printed circuit board (PCB) in water. The PCB has been designed with spacing of 0.5 mm between electrodes to allow assessment of when electrochemical migration occurs across the tracks in water. The degree of electrochemical activity is quantified by measuring current flow; low current flow is indicative of a good quality coating. The method has proved to be extremely effective at discriminating between different coatings. The performance of the coatings can be quantified, e.g. as a resistance at 4 and 8 V and 21 V. The measured resistance on the untreated test device is about 100 Ohms when 16 V/mm are applied.

The coated PCB to be tested is placed into a beaker of water and connected to the electrical test apparatus as shown in Figure 1. The board is centred horizontally and vertically in the beaker to minimise effects of local ion concentration (vertical location of the board is very important; water level should be to the blue line). When the PCB is connected, the power source is set to the desired voltage and the current is immediately monitored. The voltage applied is for example 8 V and the PCB is held at the set voltage for 13 minutes, with the current being monitored continuously during this period.

The formed coatings are tested. It has been found that when coatings have resistance values higher than 1 MOhms, the coated device will successfully pass an IPX7 test. The nature of the device being coated (for example the type of smart phone) will influence the test (for example due to the variations in materials, ingress points, power consumption etc).

### Resistance in salt water

This test method is identical to the method described above for "Resistance in tap water", except that salt water is used instead of tap water. The composition of the salt water is 5% w/v NaCl, i.e. 5 g NaCl per 100 ml water.

### Extended Electrical test

Samples were immersed in tap water under the applied voltage for an extended duration, following the same method as the tap water resistance test (see above).

### Salt fog test

Samples were placed in a chamber and exposed to 5% salt spray for 2 h. This was followed by exposure to high humidity (95% RH, 50 °C) for 22 h. This cycle was performed three times, before the samples were subjected to a tap water resistance test (see above).

### Contact force

Samples were indented with a probe measuring the force required to break through the coating and make contact with the metal below the coating.

### Handling

Samples were placed on a balance and pressed vertically with a thumb with a weight of 150 g for 30 s, for 5 or 10 applications. After thumb applications samples were subjected to a corrosion test where a droplet of water was placed on the handled part with the board under continuous voltage (8 V) for 30 s. Pass criteria was no bubbles or visible corrosion.

### Solvent resistance tests

Solvent resistance tests were done over 10 min, 30 min and 2 h, in acetone, isopropyl alcohol and hexadecane. Strip board samples were immersed vertically, to approximately the half-way mark of the board, in beakers of acetone, isopropyl alcohol and hexadecane for 10 min, 30 min and 2h with a tap water electrical resistance test (see above) between each solvent immersion.

### Adhesion of the coating to the substrate

Two tests were devised to monitor the adhesion of the coating to the substrate under stress by elevated temperature, consistent with the types of exposure a treated PCB may see during the assembly process in a factory.
(1) Thermal delamination temperature
   The test setup contained of a microscope which is used to observe changes in the coating, a digital thermometer, a hot plate, a sample holder and a video recorder (test are recorder for result confirmation). During the test, a treated PCB was heated by the hot plate, from room temperature to 125 °C or more, and the increase of the temperature was registered with the digital thermometer. The quantitative measure used to compare different coatings is the delamination temperature - when the first signs of the film rising from the substrate (bubbles) can be observed.
(2) Resistance in tap water after 5 minutes at 135 °C
   Samples were placed in an oven at 135 °C for 5 minutes. Upon removal the samples were visually inspected for any delamination, then subjected to a tap water resistance test (above).

These tests can be coupled with the surface insulation resistance tests described above (e.g. resistance in tap water) to determine whether coating barrier properties are retained after thermal challenge.

### Coating Thickness

The thickness of the coatings formed was measured using spectroscopic reflectometry apparatus (Filmetrics F20-UV) using optical constants verified by spectroscopic ellipsometry.

### Spectroscopic Ellipsometry

Spectroscopic ellipsometry is a technique for measuring the change in polarization between incident polarized light and the light after interaction with a sample (i.e. reflected, transmitted light etc). The change in polarization is quantified by the amplitude ratio Ψ and phase difference Δ. A broad band light source is used to measure this variation over a range of wavelengths and the standard values of Ψ and Δ are measured as a function of wavelength. The ITAC MNT Ellipsometer is an AutoSE from Horiba Yvon which has a wavelength range of 450 to 850nm. Many optical constants can be derived from the Ψ and Δ values, such as film thickness and refractive index.

Data collected from the sample measurements includes the intensities of the harmonics of the reflected or transmitted signal in the predefined spectral range. These are mathematically treated to extract intensity values called Is and Ic as f(I). Starting from Ic and Is the software calculates Ψ and Δ. To extract parameters of interest, such as thickness or optical constants, a model has to be set up to allow theoretical calculation of Ψ and Δ. The parameters of interest are determined by comparison of the theoretical and experimental data files to obtain the best fit (MSE or X²). The best fit for a thin layer should give an X²<3, for thicker coatings this value can be as large as 15. The model used is a three layer Laurentz model including PTFE on Si substrate finishing with a mixed layer (PTFE+voids) to account for surface roughness.

### Spectroscopy Reflectrometry

Thickness of the coating is measured using a Filmetrics F20-UV spectroscopy reflectrometry apparatus. This instrument (F20-UV) measures the coating's characteristics by reflecting light off the coating and analyzing the resulting reflectance spectrum over a range of wavelengths. Light reflected from different interfaces of the coating can be in- or out-of-phase so these reflections add or subtract, depending upon the wavelength of the incident light and the coating's thickness and index. The result is intensity oscillations in the reflectance spectrum that are characteristic of the coating.

To determine the coating's thickness, the Filmetrics software calculates a theoretical reflectance spectrum which matches as closely as possible to the measured spectrum. It begins with an initial guess for what the reflectance spectrum should look like, based on the nominal coating stack (layered structure). This includes information on the thickness (precision 0.2 nm) and the refractive index of the different layers and the substrate that make up the sample (refractive index values can be derived from spectroscopic ellipsometry). The theoretical reflectance spectrum is then adjusted by adjusting the coating's properties until a best fit to the measured spectrum is found.

Alternative techniques for measuring thickness are stylus profilometry and coating cross sections measured by SEM.

### Monomer compound

The monomer compound used in these examples was benzyl acrylate (CAS # 2495-35-4) of formula:

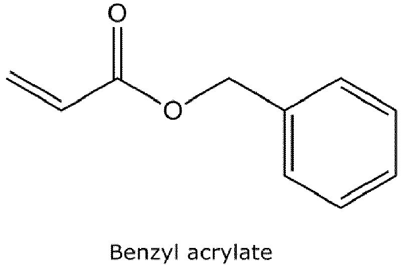

### Crosslinking reagent

The crosslinking reagent used in these examples was divinyl adipate (DVA) (CAS # 4074-90-2) of formula:

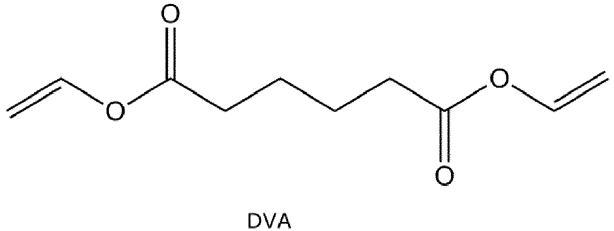

### Example 1

Plasma deposited coatings were made as follows. 9:1 (v/v) benzyl acrylate:divinyl adipate monomer was prepared by blending the two components in a bottle in the prescribed proportions. Printed circuit boards (PCBs) were loaded to the 22 L plasma chamber and the chamber was pumped down to a vacuum of around 10 mTorr. Monomer was added to the 22 L plasma chamber in a two-step process employing both continuous wave and pulse wave RF delivery.

The continuous wave step involved monomer being delivered prior to RF ignition over a period of 70 seconds (40 s with monomer only / 30 s with RF only). The process parameters for each run were as follows:
*Monomer gas flow rate: 23 seem*
*Power: 250 W*
*Set pressure: 25 mTorr*

The pulse wave period involved monomer being delivered at a power to flow ratio of 0.28 W/µl/min over a period of 200 s (for a 500 nm coating).
*Monomer gas flow rate: 100 seem*
*Power: 160 W*
*Set pressure: 30 mTorr*
*Pulse on time: 37 µs; pulse off time: 10 ms*

Following deposition, the chamber was pumped out and vented to atmosphere.

This coating was able to meet the barrier performance criteria at 500 nm thickness, achieving electrical resistance in tap water of ≥1 MOhm (applied voltage 16 V/mm) when deposited onto a PCB. Barrier performance was found to be highly repeatable.

The barrier performance of the 500 nm coating was tested using the analytical methods described above and the results are shown in Table 2.

### Examples 2 - 5

A series of experiments took place in 22L and 400L plasma chambers according to the same principles as Example 1.

The results are presented in Table 2.

**Table 2: Plasma deposited coatings**

| | **Example 1** | **Example 2** | **Example 3** | **Example 4** | **Example 5** |
|---|---|---|---|---|---|
| **Plasma chamber volume (L)** | 22 | 400 | 400 | 22 | 400 |
| **Ratio benzyl acrylate** : **divinyl adipate (v/v)** | 9:1 | 9:1 | 8:2 | 9:1 | 9:1 |
| **Thickness (nm)** | 500 | 500 | 500 | 800 | 800 |
| **Resistance in tap water, applied voltage 16V/mm (MOhm)** | ≥10 | ≥10 | >10 | >10 | >10 |
| **Extended electrical test duration (h)** | | | | | 95 (18/18) |
| **Solvent Resistance after 2 h - pass rate (no. of samples/samples tested)** | | | | 100% (18/18) | |
| **Number of handling applications before visible corrosion (no. of samples/samples tested)** | | | | 10 (6/6) | 5 (18/18) |
| **Resistance in tap water, applied voltage 16V/mm (MOhm) after 3 salt fog exposure cycles (no. of samples/samples tested)** | | | | | 100% (18/18) |
| **Thermal delamination temperature (°C) (no. of samples/samples tested)** | | | | ≥140 (6/6) | |
| **Resistance in tap water, applied voltage 16V/mm (MOhm) after 5 min at 135 °C (no. of samples/samples tested)** | | 94% >1 (33/35) | 97% >1 (35/36) | | |
| **Contact force (g)** | | <200 | <200 | ≤ 500 | <400 |

### CLAUSES

The following clauses define particular features of the invention.
Clause 1. A substrate bearing a polymeric nanocoating, wherein the coating comprises (i) aromatic moieties and (ii) carbonyl moieties.
Clause 2. The substrate of clause 1, wherein the polymeric nanocoating has a thickness of 15,000 nm or less.
Clause 3. The substrate of clause 1 or 2, wherein the polymeric nanocoating has a thickness of 1 nm or more.
Clause 4. The substrate of any of the preceding clauses, wherein the polymeric nanocoating does not contain fluorine.
Clause 5. The substrate of any of the preceding clauses, wherein the polymeric nanocoating does not contain halogens.
Clause 6. The substrate of any of the preceding clauses, wherein the aromatic moieties comprise optionally substituted phenyl groups.
Clause 7. A method for forming a polymeric nanocoating on a substrate, the method comprising exposing the substrate to a plasma comprising one or more unsaturated monomeric species for a period of time sufficient to allow the coating to form on the substrate, wherein the one or more unsaturated monomeric species comprise (i) an aromatic moiety and (ii) a carbonyl moiety.
Clause 8. The method of clause 7, wherein the one or more unsaturated monomeric species comprise a monomer compound which is unsaturated and comprises (i) an aromatic moiety and (ii) a carbonyl moiety.
Clause 9. The method of clause 7, wherein the monomer compound comprises moiety A or B: 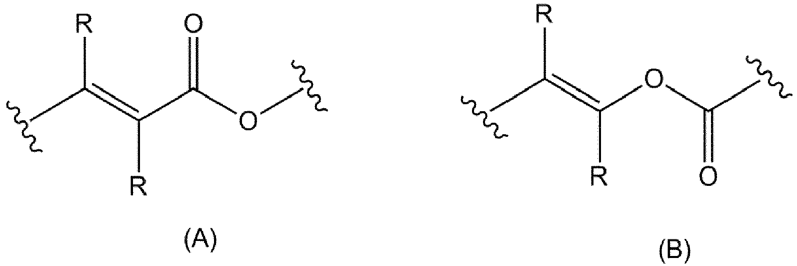 wherein each R is independently selected from hydrogen, optionally substituted branched or straight chain alkyl, or optionally substituted cycloalkyl.
Clause 10. The method of clause 8 or 9, wherein the monomer compound is a compound of formula (I):

   Q-Z-Ar (I)

   wherein
   Q is selected from structures (Qa) and (Qb): 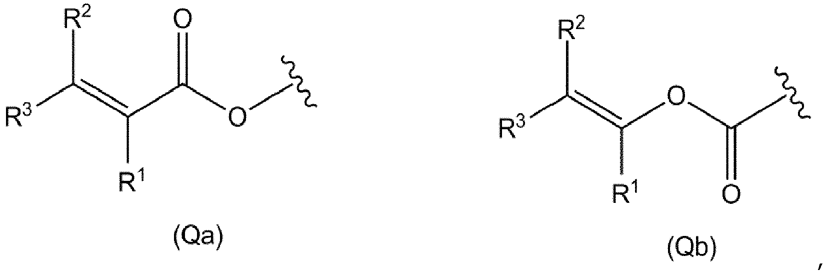 wherein each of R¹, R² and R³ is independently selected from hydrogen, optionally substituted branched or straight chain C₁-C₆ alkyl, or optionally substituted C₃-C₈ cycloalkyl;
   Z is a direct bond or a linker moiety; and
   Ar is an optionally substituted aromatic moiety.
Clause 11. The method of clause 10, wherein each of R¹, R² and R³ is independently selected from hydrogen, methyl, ethyl, n-propyl, isopropyl, n-butyl, isobutyl, tert-butyl, sec-butyl, n-pentyl, neopentyl, n-hexyl, isohexyl, and 3-methylpentyl.
Clause 12. The method of clause 11, wherein each of R¹, R² and R³ is hydrogen.
Clause 13. The method of any of clauses 10 to 12, wherein the monomer compound of formula (I) is a compound of formula (Ia): 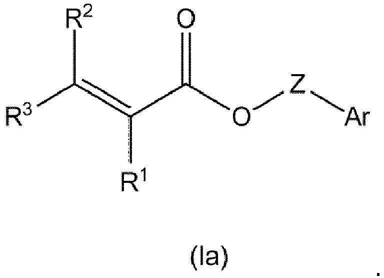
Clause 14. The method of any of clause s 10 to 13, wherein Z has the formula:

   -(CH₂)ₙ-

   where n is an integer from 0 to 27.
Clause 15. The method of clause 14, wherein n is an integer from 0 to 2.
Clause 16. The method of clause 15, wherein n is 1.
Clause 17. The method of any of clauses 10 to 16, wherein Ar is an optionally substituted monocyclic aromatic moiety or an optionally substituted bicyclic aromatic moiety.
Clause 18. The method of clause 17, wherein Ar is an optionally substituted C₃-C₁₂ aryl group.
Clause 19. The method of clause 18, wherein Ar is optionally substituted phenyl.
Clause 20. The method of any of clauses 8 to 19, wherein the monomer compound is benzyl acrylate.
Clause 21. The method of any of clauses 8 to 19, wherein the monomer compound does not contain any fluorine atoms.
Clause 22. The method of clause 7, wherein the one or more unsaturated monomeric species comprise a crosslinking reagent.
Clause 23. The method of any of clauses 8 to 21, wherein the one or more unsaturated monomeric species further comprise a crosslinking reagent.
Clause 24. The method of clause 22 or clause 23, wherein the crosslinking reagent comprises (i) an aromatic moiety and (ii) a carbonyl moiety.
Clause 25. The method of any of clauses 22 to 24, wherein the crosslinking reagent is independently selected from a compound of formula (II) or (III): 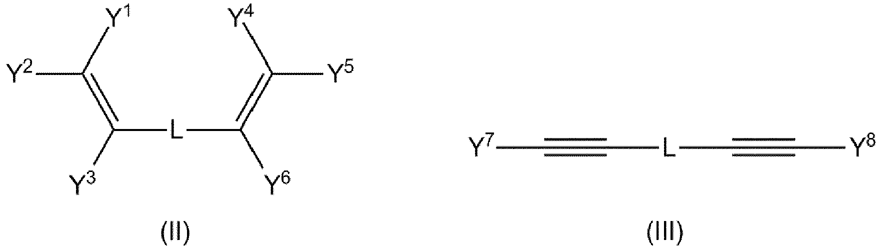 wherein
   Y¹, Y², Y³, Y⁴, Y⁵, Y⁶, Y⁷ and Y⁸ are each independently selected from hydrogen, optionally substituted branched or straight chain C₁-C₆ alkyl, optionally substituted C₁-C₆ cycloalkyl, and optionally substituted C₁-C₆ aryl; and
   L is a linker moiety.
Clause 26. The method of clause 25, wherein group L has the formula: 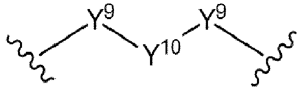 wherein
   each Y⁹ is independently selected from a bond, -O-, -O-C(O)-, -C(O)-O-, -Y¹¹-O-C(O)-,
   -CCO)-O-Y¹¹-, -O-CCO)-Y¹¹-, -Y¹¹-C(O)-O-, -OY¹¹-, and -Y¹¹O-, wherein Y¹¹ is an optionally substituted branched, straight chain or cyclic C₁-C₈ alkylene; and
   Y¹⁰ is selected from an optionally substituted branched, straight chain or cyclic C₁-C₈ alkylene, arylene, and a siloxane group.
Clause 27. The method of any of clauses 22 to 26, wherein the crosslinking reagent is independently selected from divinyl adipate (DVA), 1,4-butanediol divinyl ether (BDVE), 1,4-cyclohexanedimethanol divinyl ether (CDDE), 1,7-octadiene (170D), 1,2,4-trivinylcyclohexane (TVCH), 1,3-divinyltetramethyldisiloxane (DVTMDS), diallyl 1,4-cyclohexanedicarboxylate (DCHD), glyoxal bis(diallyl acetal) (GBDA), and 1,4-phenylene diacrylate.
Clause 28. The method of any of clauses 22 to 27, wherein the crosslinking reagent is divinyl adipate (DVA).
Clause 29. The method of any of clauses 22 to 27, wherein the crosslinking reagent does not contain any fluorine atoms.
Clause 30. A substrate bearing a polymeric nanocoating, wherein the coating is obtainable by the method of any of clauses 7 to 29.

## Claims

1. A method for forming a polymeric nanocoating on a substrate, the method comprising exposing the substrate to a plasma comprising one or more unsaturated monomeric species for a period of time sufficient to allow the coating to form on the substrate,
wherein the one or more unsaturated monomeric species comprise a monomer compound which is unsaturated and comprises (i) an aromatic moiety and (ii) a carbonyl moiety, and wherein the one or more unsaturated monomeric species further comprises a crosslinking reagent
wherein the crosslinking reagent is independently selected from a compound of formula (II) or (III): 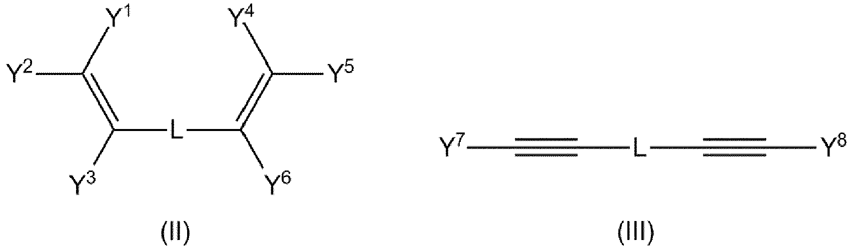 wherein
Y¹, Y², Y³, Y⁴, Y⁵, Y⁶, Y⁷ and Y⁸ are each independently selected from hydrogen, optionally substituted branched or straight chain C₁-C₆ alkyl, optionally substituted C₁-C₆ cycloalkyl, and optionally substituted C₁-C₆ aryl; and
L is a linker moiety which has the formula: 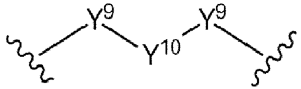 wherein
each Y⁹ is independently selected from a bond, -O-, -O-C(O)-, -C(O)-O-, -Y¹¹-O-C(O)-, -C(O)-O-Y¹¹-, -O-C(O)-Y¹¹-, -Y¹¹-C(O)-O-, -OY¹¹-, and -Y¹¹O-, wherein Y¹¹ is an optionally substituted branched, straight chain or cyclic C₁-C₈ alkylene; and
Y¹⁰ is selected from an optionally substituted branched, straight chain or cyclic C₁-C₈ alkylene, and an arylene.

2. The method of claim 1, wherein the monomer compound comprises moiety A or B: 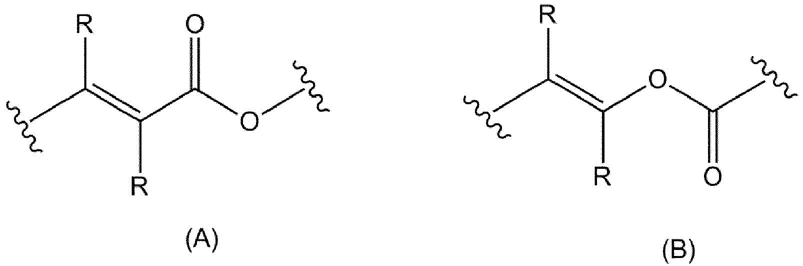 wherein each R is independently selected from hydrogen, optionally substituted branched or straight chain alkyl, or optionally substituted cycloalkyl.

3. The method of claim 2, wherein the monomer compound is a compound of formula (I):
Q-Z-Ar (I)
wherein
Q is selected from structures (Qa) and (Qb): 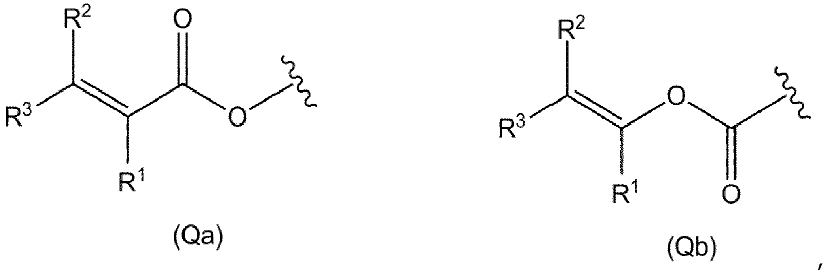 wherein each of R¹, R² and R³ is independently selected from hydrogen, optionally substituted branched or straight chain C₁-C₆ alkyl, or optionally substituted C₃-C₈ cycloalkyl;
Z is a direct bond or a linker moiety; and
Ar is an optionally substituted aromatic moiety.

4. The method of claim 3, wherein each of R¹, R² and R³ is independently selected from hydrogen, methyl, ethyl, n-propyl, isopropyl, n-butyl, isobutyl, tert-butyl, sec-butyl, n-pentyl, neopentyl, n-hexyl, isohexyl, and 3-methylpentyl, preferably wherein each of R¹, R² and R³ is hydrogen.

5. The method of any of claim 3 or 4, wherein the monomer compound of formula (I) is a compound of formula (Ia):

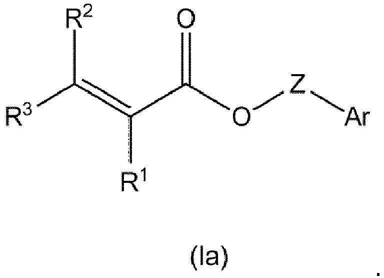

6. The method of any of claims 3 to 5, wherein Z has the formula:
-(CH₂)ₙ-
where n is an integer from 0 to 27, preferably wherein n is an integer from 0 to 2, more preferably wherein n is 1.

7. The method of any of claims 3 to 6, wherein Ar is an optionally substituted monocyclic aromatic moiety or an optionally substituted bicyclic aromatic moiety, preferably wherein Ar is an optionally substituted C₃-C₁₂ aryl group, more preferably wherein Ar is optionally substituted phenyl.

8. The method of any of claims 1 to 7, wherein the monomer compound is benzyl acrylate.

9. The method of any of claims 1 to 7, wherein the monomer compound does not contain any fluorine atoms.

10. The method of claim 1, wherein the crosslinking reagent comprises (i) an aromatic moiety and (ii) a carbonyl moiety.

11. The method of claim 1, wherein the crosslinking reagent is independently selected from divinyl adipate (DVA), 1,4-butanediol divinyl ether (BDVE), 1,4-cyclohexanedimethanol divinyl ether (CDDE), 1,7-octadiene (170D), 1,2,4-trivinylcyclohexane (TVCH), diallyl 1,4-cyclohexanedicarboxylate (DCHD), glyoxal bis(diallyl acetal) (GBDA), and 1,4-phenylene diacrylate.

12. The method of claim 1 or 11, wherein the crosslinking reagent is divinyl adipate (DVA).

13. The method of claim 1 or 11, wherein the crosslinking reagent does not contain any fluorine atoms.

14. A substrate bearing a polymeric nanocoating, wherein the coating is obtainable by the method of any preceding claim.

15. The substrate according to claim 14, wherein the polymeric nanocoating has a thickness of 15,000 nm or less, preferably wherein the polymeric nanocoating has a thickness of 1 nm or more.
